# FASCICULE DE BREVET EUROPEEN

(11) **EP 0 905 759 B1**
(45) Date de publication et mention de la délivrance du brevet: **17.12.2003**
(21) Numéro de dépôt: 98401433.2
(22) Date de dépôt: 12.06.1998
(51) Int. Cl.: H01L 21/3213

(54) **Procédé de gravure d'une couche de Si1-xGex polycristallin ou d'un empilement d'une couche de Si1-x Gex polycristallin et d'une couche de Si polycristallin, et son application à la microélectronique**
Verfahren zum Ätzen einer aus Si1-xGex polykristallinen Schicht oder einer aus polykristallinen Si1-xGex/Si Stapelschicht, und Verwendung in der Herstellung von elektronischen Anordnungen
Process for etching a polycristalline Si1-xGex layer or stacked layers of polycristalline Si1-xGex and Si, and application to electronic devices

(30) Priorité: 25.06.1997 FR 9707940
(43) Date de publication de la demande: 31.03.1999
(73) Titulaire: FRANCE TELECOM, 75015 Paris (FR)
(72) Inventeur: Monget, Cédric, 38100 Grenoble (FR); Vallon, Sophie, 78000 Versailles (FR); Joubert, Olivier, 38240 Meylan (FR)
(74) Mandataire: Casalonga, Axel

(56) Documents cités:
- EP-A- 0 212 585
- EP-A- 0 746 015
- US-A- 5 521 108
- RICHTER H H ET AL: "OPTICAL EMISSION END POINT DETECTION FOR REACTIVE ION ETCHING OF SI/SIGE STRUCTURES" MATERIALS SCIENCE AND ENGINEERING B, vol. B27, no. 1, octobre 1994, pages 39-45, XP000483567

## Description

La présente invention concerne de manière générale le domaine de la gravure par plasma haute densité pour la réalisation de structures submicroniques utilisées en microélectronique.

Plus particulièrement, la présente invention concerne un procédé de gravure anisotrope par plasma haute densité d'une couche de Si₁₋ₓGeₓ (0 < x ≤ 1), et en particulier d'un empilement de couches comprenant une première couche de Si₁₋ₓGeₓ, et sur cette première couche une seconde couche de silicium.

Le matériau généralement utilisé pour former la grille d'un dispositif semi-conducteur CMOS, en particulier dans le cas de dispositifs à canal court ≤ 0,18 µm, est le silicium amorphe (a-Si). De manière classique, les grilles de ces dispositifs sont obtenues par gravure par plasma haute densité d'une couche de a-Si déposée sur une mince couche d'oxyde de silicium (oxyde de grille) formée à la surface d'un substrat en silicium. Cette étape de gravure doit être anisotrope pour que les flancs du motif a-Si finalement obtenu soient parfaitement droits afin de respecter la dimension imposée par le masque préalablement défini par une étape de photolithographie. D'autre part, et c'est une des principales difficultés de l'étape de gravure de la grille d'un dispositif CMOS, il ne faut pas percer l'oxyde de silicium sous-jacent afin de ne pas endommager les futures zones actives du dispositif, ce qui impose que la consommation de l'oxyde de silicium soit la plus faible possible.

L'étape de gravure proprement dite consiste à soumettre la couche du matériau à graver, par exemple a-Si, sur laquelle on a préalablement formé un motif de masquage par photolithogravure à un plasma réactif utilisant un gaz ou un mélange de gaz qui réagit chimiquement avec le matériau à graver pour former des produits de réaction volatiles qui désorbent spontanément ou sous l'influence du bombardement ionique. Les cinétiques de gravure observées dans les plasmas dépendent d'une part d'un phénomène de dissociation du gaz ou du mélange de gaz à l'origine de la production d'espèces atomiques réactives et, d'autre part, de l'ionisation du gaz ou du mélange de gaz qui produit des ions positifs permettant un bombardement ionique, normal à la surface du substrat porté à un potentiel négatif par rapport au potentiel du plasma.

L'opération de gravure proprement dite est induite par le plasma dont l'action de gravure peut être décomposée en une vitesse de gravure verticale Vv de direction normale à la surface du substrat et une vitesse de gravure latérale Vl spontanée, dirigée vers les flancs de gravure non soumis au bombardement ionique.

En pratique, pour obtenir un profil de gravure anisotrope, il est connu que le bombardement ionique doit être intense et énergétique de façon à privilégier la vitesse verticale de gravure Vv assistée par le bombardement ionique et minimiser la vitesse latérale Vl spontanée, c'est-à-dire les réactions de gravure spontanées entre flancs de gravure et espèces réactives du plasma. L'anisotropie de gravure est obtenue dans certains cas par formation d'une couche mince de passivation sur les flancs du motif gravé, ce qui permet de protéger les flancs du motif gravé des attaques spontanées par les espèces réactives produites par la décharge.

Dans le cas spécifique de la gravure de a-Si, il est nécessaire d'obtenir, d'une part, une gravure anisotrope et, d'autre part, de minimiser la consommation de l'oxyde de grille. Les procédés de gravure du a-Si sont généralement constitués de trois étapes.

La première étape au cours de laquelle l'énergie de polarisation appliquée au substrat est élevée (typiquement dans une source plasma haute densité industrielle dont la densité ionique est comprise entre 5 10¹¹ et 10¹² ions pr cm⁻³, la puissance de polarisation appliquée à un substrat de diamètre 200 mm est de 400 W), permet de graver la couche mince d'oxyde natif de silicium à la surface du a-Si qui se forme naturellement à l'air.

La seconde étape que l'on appelle étape de gravure principale, permet d'obtenir l'anisotropie du profil de gravure : la puissance de polarisation d'un substrat de diamètre 200 mm est alors comprise entre 100 et 150 W selon les sources de plasma haute densité utilisées.

La troisième étape n'est déclenchée que lorsqu'une détection de fin d'attaque est obtenue à l'issue de l'étape de gravure principale et donc lorsque tout le a-Si est gravé dans les zones ouvertes du substrat (c'est-à-dire les zones sans motifs). Cette étape, que l'on appelle l'étape de surgravure, est nécessaire pour terminer la gravure dans les zones denses du substrat, c'est-à-dire les zones dans lesquelles les grilles peuvent être séparées par une distance inférieure à 0,5 micromètre. En effet, dans ces zones denses, la vitesse de gravure du a-Si peut être jusqu'à 20-30% plus faible que dans les zones ouvertes. L'étape de surgravure doit donc être suffisamment longue pour permettre de graver le a-Si restant après l'étape de gravure principale quel que soit l'endroit sur le substrat. Dans la pratique, sa durée représente 50% du temps de l'étape de gravure principale et peut même être prolongée jusqu'à 100% dans le cas de substrats présentant une topographie sévère. Au cours de cette étape, l'oxyde de grille est exposé au plasma dans les zones ouvertes. Les conditions du plasma doivent donc être ajustées pour ne pas le détériorer. En pratique, la puissance de polarisation appliquée au substrat de diamètre 200 mm est réduite à des valeurs inférieures à 60 W de façon à diminuer sensiblement l'énergie des ions et donc augmenter la sélectivité entre le a-Si et l'oxyde de silicium (la sélectivité est définie comme le rapport des vitesses de gravure).

La chimie utilisée pour graver le silicium amorphe utilise généralement des gaz tels que Cl_{2,} HBr, HCI, Br₂. Pour préserver l'oxyde de grille, O₂ est ajouté dans la phase gazeuse (pendant l'étape de surgravure ou éventuellement le procédé complet) pour augmenter la sélectivité a-Si/oxyde de grille. Les chimies les plus couramment utilisées pour graver a-Si sont les mélanges HBr/Cl₂/O_{2,} et HBr/O₂. Chaque gaz du mélange a un rôle bien précis : le chlore permet d'obtenir une vitesse de gravure élevée et favorise l'obtention de profils de gravure anisotropes (le chlore atomique produit par la décharge ne réagit pas spontanément avec le a-Si du flanc de gravure). Un des inconvénients lié à l'utilisation du chlore est de générer une accélération de la vitesse de gravure du a-Si au bord des grilles (phénomène plus connu en gravure plasma sous le nom de "trenching"). Il en résulte qu'au bord de la grille, l'oxyde de silicium peut être exposé au plasma avant la détection de fin d'attaque de l'étape de gravure principale. Dans le cas de couches d'oxyde de silicium de grille très mince (épaisseur < 5 nm), cette accélération de la vitesse de gravure au bord des grilles peut générer un perçage de l'oxyde au bord des grilles. L'addition de HBr dans la phase gazeuse permet de réduire ce phénomène. En effet, l'apport de HBr (qui génère moins ce phénomène que le chlore) permet de diminuer la pression partielle de chlore dans la phase gazeuse et donc de diminuer l'amplitude du phénomène. HBr permet également d'augmenter sensiblement la sélectivité a-Si/oxyde de grille. L'oxygène, qui permet d'améliorer nettement la sélectivité a-Si/oxyde de grille, favorise également la formation d'une couche de passivation qui protège les flancs de a-Si pendant la gravure. Cette couche de passivation est un oxyde sous-stoechiométrique fortement chloré de composition approximative SiOCl. La composition exacte et l'épaisseur de cet oxyde peuvent dépendre de la source plasma haute densité utilisée et du mélange de gaz, mais l'anisotropie de gravure de a-Si est toujours obtenue par formation de cette couche de passivation sur les flancs de gravure.

On a proposé de remplacer le silicium amorphe comme matériau de grille d'un dispositif semi-conducteur CMOS, en particulier pour la réalisation de dispositifs à canal court ≤ 0,18 µm, par un empilement d'une première couche de silicium-germanium polycristallin (Si₁₋ₓGeₓ, 0 < x ≤ 1) déposée directement sur l'oxyde de grille. Sur cette première couche de silicium-germanium polycristallin est généralement déposée une seconde couche de silicium, par exemple du silicium polycristallin. L'avantage essentiel lié au remplacement de la couche de a-Si par cet empilement silicium-germanium polycristallin/silicium (poly Si₁₋ₓGeₓ/Si) est l'obtention d'une grille qui, à partir d'un dopage unique P+, remplace les grilles duales N+ et P+ qui permettent d'obtenir des dispositifs PMOS et NMOS.

Comme dans le cas de la gravure d'une couche de a-Si, le procédé de gravure de l'empilement poly Si₁₋ₓGeₓ/Si doit être anisotrope et le profil de gravure doit être droit tant dans la couche de poly Si₁₋ₓGeₓ que dans la couche de Si.

Malheureusement, comme on le montrera ci-après, les procédés de gravure par plasma haute densité utilisés classiquement pour la gravure de a-Si ne conviennent pas pour la gravure d'une couche de poly Si₁₋ₓGeₓ ou d'un empilement poly Si₁₋ₓGeₓ/Si, en particulier lorsque la teneur en germanium de la couche de poly Si₁₋ₓGeₓ est supérieure à 50% (x ≥ 0,5). En effet, les procédés de gravure par plasma classiques conduisent à des déformations des profils des motifs gravés, en particulier des flancs de ceux-ci.

Dans le document Richter et al : "Optical emission end point detection for reactive ion etching of Si/SiGe structures", Materials Science and Engineering, vol. B27, n°1, (Octobre 1994), pages 39-45, il est décrit un procédé de gravure de structures Si /SiGe déposées sur silicium utilisant un plasma de Cl₂/SiCl₄/N₂.

La présente invention a donc pour objet un procédé de gravure d'une couche de poly Si₁₋ₓGeₓ remédiant aux inconvénients ci-dessus et en particulier évitant une gravure des flancs des motifs formés.

L'invention a également pour objet un procédé de gravure d'un empilement poly Si₁₋ₓGeₓ/poly Si qui remédie aux inconvénients ci-dessus, et en particulier évitant la gravure des flancs des motifs formés.

Selon l'invention, on fournit un procédé de gravure d'une couche de Si₁₋ₓGeₓ (0 < x ≤ 1) déposée sur un substrat et comportant à sa surface un masque en matériau inorganique, caractérisé en ce qu'il comprend une étape de gravure principale, anisotrope, de la couche de Si₁₋ₓGeₓ, en utilisant ledit masque, au moyen d'un plasma gazeux haute densité d'un mélange de gaz Cl₂ et soit N₂ ou NH₃, soit un mélange N₂/NH₃.

Selon un autre aspect de l'invention, on fournit un procédé de gravure d'un empilement de couches sur un substrat, l'empilement comprenant une première couche de Si₁₋ₓGeₓ polycristallin déposée sur le substrat et une deuxième couche de silicium sur la première couche et comportant à sa surface un masque en matériau inorganique, caractérisé en ce qu'il comprend une étape de gravure principale, anisotrope, dudit empilement, en utilisant ledit masque, au moyen d'un plasma gazeux haute densité d'un mélange de gaz Cl₂ et soit N₂ ou NH₃, soit un mélange N₂/NH₃.

Le procédé de gravure selon l'invention convient particulièrement pour la gravure d'une couche de Si₁₋ₓGeₓ polycristallin ou d'un empilement comprenant une première couche de Si₁₋ₓGeₓ polycristallin ayant une teneur en germanium de 50% ou plus (x ≥ 0,5), y compris une couche en germanium polycristallin pur (x = 1), et de préférence ayant une teneur en germanium comprise entre 70% et 100% (0,70 ≤ x ≤ 1), et mieux entre 75% et 100% (0,75 ≤ x ≤ 1).

Dans le cas où l'empilement est destiné à former la structure de grille d'un dispositif semi-conducteur CMOS, la couche de poly Si₁₋ₓGeₓ a généralement une épaisseur comprise entre 25 et 200 nm, de préférence 30 à 190 nm, cependant que la couche de Si peut avoir une épaisseur allant jusqu'à 200 nm, de préférence comprise entre 50 et 100 nm.

De préférence, l'épaisseur totale de l'empilement est comprise entre 150 et 200 nm, une épaisseur de 200 nm étant particulièrement recommandée dans le cas de dispositifs à canal court ≤ 0,18 µm.

La couche de silicium-germanium polycristallin ou les couches de l'empilement peuvent être des couches dopées, par exemple avec des atomes de bore ou de phosphore, comme cela est bien connu dans la technique de fabrication des dispositifs semi-conducteurs CMOS.

Préalablement à l'étape de gravure principale, selon l'invention, on forme, de manière classique, un masque en matériau inorganique, qui comprend le dépôt, par un procédé classique tel qu'un dépôt en phase vapeur à basse pression, d'un matériau inorganique, par exemple une couche de SiO₂ ou une double couche de SiO₂/SiON.

Après formation sur cette couche de matériau inorganique d'un masque de résine classique, par exemple par photolithogravure, le masque en matériau inorganique est gravé, de préférence par gravure par plasma haute densité.

Une caractéristique essentielle du procédé de l'invention consiste en une étape de gravure principale, anisotrope, au moyen d'un plasma gazeux haute densité à base de chlore, exempte d'oxygène et de HBr et incluant N₂ ou NH₃ ou leur mélange pour réaliser une couche de passivation des flancs de gravure par co-adsorption avec le chlore atomique afin de réduire la vitesse latérale Vl de gravure spontanée par le chlore. Cette addition de N₂ ou NH₃ ou d'un mélange de ces composés entraîne peu ou pas de résidu de gravure, et ne provoque pas d'érosion latérale ou d'altération de la couche de poly Si₁₋ₓGeₓ ou de l'oxyde de grille sous-jacent. En outre, l'utilisation d'un tel mélange gazeux est compatible avec des mises en oeuvre industrielles du procédé de gravure.

Les proportions de N₂ et/ou NH₃ introduites dans le mélange gazeux du plasma peuvent être déterminées expérimentalement, de manière classique, et doivent être suffisantes pour bloquer les cinétiques des réactions chimiques spontanées responsables de la gravure latérale des flancs des motifs gravés non soumis au bombardement ionique, sans pour autant bloquer les cinétiques des réactions induites par le bombardement ionique responsable de la gravure verticale.

De préférence, dans le procédé de la présente invention, l'étape de gravure principale est suivie d'une étape de surgravure comme dans le cas de la gravure d'une couche de silicium amorphe dans laquelle l'énergie des ions du plasma est réduite par rapport à l'étape de gravure principale. Lors de cette étape de surgravure, on peut utiliser le même mélange gazeux que dans l'étape de gravure principale, mais on peut également utiliser des mélanges gazeux contenant de l'oxygène, car la couche de passivation formée par les flancs du motif gravé au cours de l'étape de gravure principale avec le mélange gazeux exempt d'oxygène et de HBr protège les flancs du motif gravé d'une gravure spontanée par les atomes d'oxygène pendant cette étape de surgravure. Cette étape de surgravure s'effectue généralement dans des conditions de polarisation du substrat dans lesquelles l'énergie ne dépasse pas 60 W.

La quantité d'oxygène peut être déterminée expérimentalement pour accroître la sélectivité poly Si₁₋ₓGeₓ/oxyde de grille sans entraîner une gravure latérale spontanée des motifs gravés.

De préférence encore, l'étape de gravure principale est arrêtée avant d'atteindre le substrat, par exemple la couche d'oxyde de silicium sous-jacente, de préférence à une distance comprise entre 30 et 40 nm du substrat sous-jacent. On évite ainsi tout risque de dégradation du substrat sous-jacent, en particulier de l'oxyde de grille pendant l'étape de gravure principale.

### Exemple comparatif A

On forme de manière classique sur une couche d'oxyde de silicium d'un substrat, un empilement d'une première couche de Si_{0,45}Ge_{0,55} polycristallin (120 nm d'épaisseur) et d'une seconde couche de silicium polycristallin (80 nm d'épaisseur). Sur la seconde couche de silicium polycristallin, on dépose une couche de masquage en un matériau inorganique, par exemple une couche d'oxyde de silicium.

Après formation de façon classique d'un masque de résine sur la couche de masquage en matériau inorganique et de la gravure du masque en matériau inorganique effectuée par plasma à partir de gaz fluorocarbonés et d'un retrait de la résine de masquage, on effectue la gravure de l'empilement dans les conditions indiquées dans le tableau I ci-dessous.

**TABLEAU I**

| Plasma | | | | |
|---|---|---|---|---|
| | Mélange de gaz | Puissance de la source (W) | Puisance de polarisation appliquée au porte-substrat (W) | Durée du traitement(s) |
| Percement de la couche d'oxyde en surface du silicium polycristallin | HBr/Cl₂/O₂ (40/40//8)* | 2500 | 400 | 5 |
| | | | | |
| Etape de gravure principale | HBr/Cl₂/O₂ (40/40/8) | 2500 | 150 | 52 |
| | | | | |
| Etape de surgravure | HBr/O₂ (60/8) | 2500 | 60 | 26 |

| | | | | |
|---|---|---|---|---|
| * Dans les exemples, sauf indication contraire, tous les débits de gaz sont exprimés en cm³/minute dans les conditions standards. | | | | |

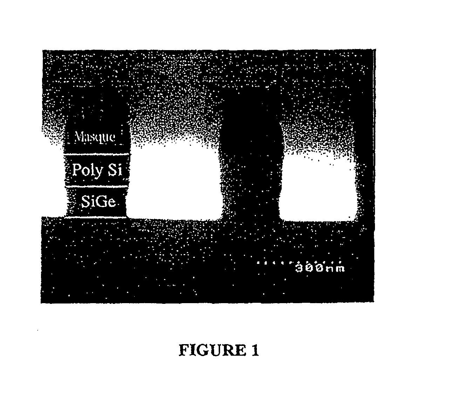

Comme le montre la figure 1, qui est une photomicrographie de l'empilement après gravure, on observe une forte déformation du profil de gravure des motifs dans les flancs de la couche de Si_{0,45}Ge_{0,55} polycristallin. Une analyse par spectroscopie de photoélectrons X de l'épaisseur de la couche d'oxyde qui passive les flancs des motifs gravés, montre que celle-ci a une épaisseur de 1 nm sur les flancs de la couche de Si_{0,45}Ge_{0,55} polycristallin contre 3 nm sur les flancs de la couche de silicium polycristallin.

Comme dans le cas du silicium polycristallin, la couche de passivation des flancs de Si_{0,45}Ge_{0,55} est un oxyde de silicium sous stoechiométrique fortement chloré. La couche de passivation ne se forme donc qu'à partir des produits de réaction de gravure du silicium, ce qui explique que son épaisseur sur le flanc du motif gravé diminue pour la couche de Si_{0,45}Ge_{0,55}.

### Exemples comparatifs B et C

En procédant de façon analogue à l'exemple comparatif A, mais en utilisant les conditions du tableau II ci-dessous, on a gravé deux empilements semblables à celui de l'exemple comparatif A, mais dans lesquels on a remplacé la première couche de Si_{0,45}Ge_{0,55} polycristallin par une couche de Si_{0,25}Ge_{0,75} polycristallin et une couche de Ge polycristallin, respectivement.

**TABLEAU II**

| Plasma | | | | |
|---|---|---|---|---|
| | Mélange de gaz | Puissance de la source (W) | Puisance de polarisation appliquée au porte-substrat (W) | Durée du traitement(s) |
| Percement de la couche d'oxyde en surface du silicium polycristallin | Cl₂/O₂ (80/8) | 2500 | 400 | 5 |
| | | | | |
| Etape de gravure principale (arrêtée 30-40 nm avant d'atteindre l'oxyde de silicium du substrat) | Cl₂/O₂ (80/8) | 2500 | 150 | 13 |
| | | | | |
| Etape de surgravure | Cl₂/O₂ (60/8) | 2500 | 60 | 23 |

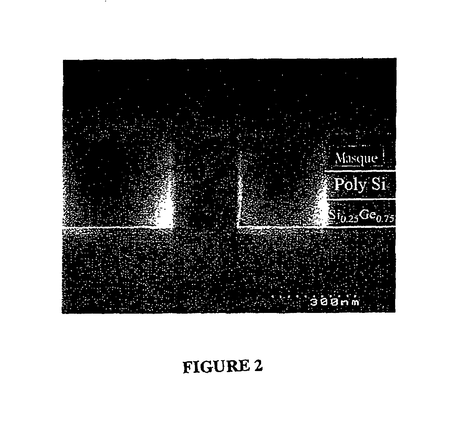

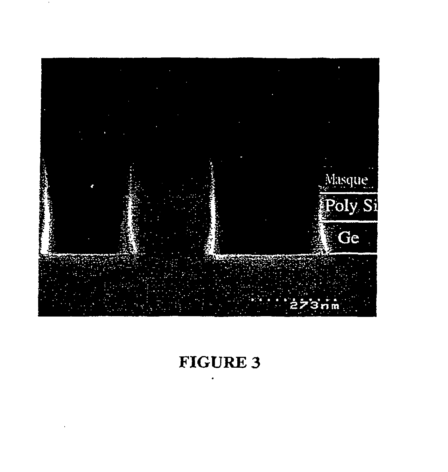

Comme le montrent les figures 2 (exemple comparatif B) et 3 (exemple comparatif C) qui sont des microphotographies analogues à la figure 1, il y a une déformation des profils de gravures dans les couches de Si_{0,25}Ge_{0,75} polycristallin et Ge polycristallin.

Ainsi, l'élimination de HBr ne suffit pas pour éviter la déformation des profils, en particulier pour des teneurs élevées en germanium de la couche Si₁₋ₓGeₓ polycristallin.

### Exemple comparatif D

On a reproduit l'exemple comparatif C, mais en éliminant l'oxygène du mélange gazeux du plasma.

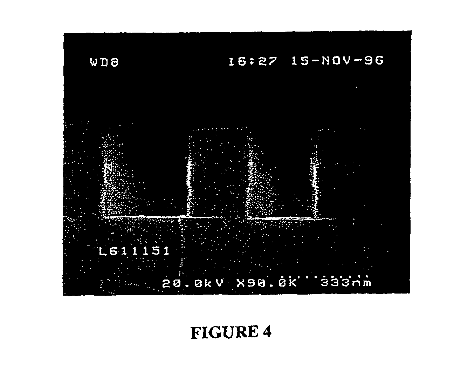

La figure 4 montre que le profil de gravure est parfaitement droit dans la couche de silicium polycristallin alors qu'on observe une déformation dans la couche de germanium polycristallin, ce qui montre que les atomes neutres de chlore attaquent spontanément le germanium polycristallin.

### Exemples 1 et 2

En procédant de manière analogue aux exemples comparatifs B et C, mais en utilisant les conditions du tableau III ci-dessous, on a gravé deux empilements comprenant une première couche de Si_{0,25}Ge_{0,75} polycristallin et de Ge polycristallin, respectivement, et une couche de silicium polycristallin.

**TABLEAU III**

| Plasma | | | | |
|---|---|---|---|---|
| | Mélange de gaz | Puissance de la source (W) | Puisance de polarisation appliquée au porte-substrat (W) | Durée du traitement(s) |
| Percement de la couche d'oxyde en surface du silicium polycristallin | Cl₂/N₂ (73/7) | 2500 | 400 | 5 |
| | | | | |
| Etape de gravure principale (arrêtée 30-40 nm avant d'atteindre l'oxyde de silicium du substrat) | Cl₂N₂ (73/7) | 2500 | 150 | 13 |
| | | | | |
| Etape de surgravure | Cl₂N₂ (60/7) | 2500 | 60 | 23 |

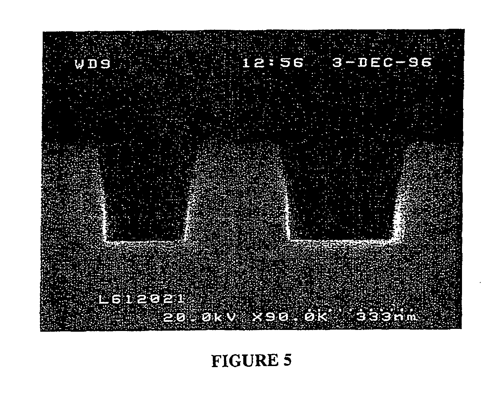

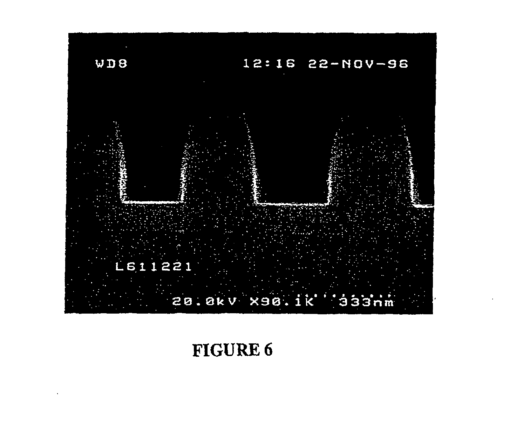

Les figures 5 (exemple 1) et 6 (exemple 2) montrent que dans des conditions analogues, en utilisant un mélange Cl₂/N₂, exempt de HBr et O₂, on n'observe aucune déformation des flancs des motifs gravés, et tout particulièrement pour des teneurs élevées en germanium (égales ou supérieures à 75%).

La présente invention fournit donc une procédure de gravure d'un empilement de deux couches dont une couche est constituée par un mélange polycristallin de silicium et de germanium qui évite la déformation des flancs des motifs gravés, même pour des teneurs élevées en germanium.

Le procédé selon l'invention convient particulièrement pour la formation d'une structure de grille de dispositifs semi-conducteurs CMOS comprenant une couche de Si₁₋ₓGeₓ polycristallin déposée sur une couche d'oxyde de silicium.

## Revendications

1. Procédé de gravure d'une couche d'un mélange polycristallin Si₁₋ₓGeₓ (0 < x ≤ 1) déposée sur un substrat ou d'un empilement comprenant une première couche d'un mélange polycristallin Si₁₋ₓGeₓ (0 < x ≤ 1) déposée sur un substrat et une deuxième couche de silicium sur la première couche, ladite couche ou ledit empilement comportant sur sa surface un masque en matériau inorganique, **caractérisé en ce qu'**il comprend une étape de gravure principale, anisotrope, de ladite couche de Si₁₋ₓGeₓ ou dudit empilement, en utilisant ledit masque, au moyen d'un plasma gazeux haute densité d'un mélange de gaz constitué de chlore (Cl₂) et, soit d'azote (N₂) ou d'ammoniac (NH₃), soit d'un mélange d'azote et d'ammoniac.

2. Procédé de gravure selon la revendication 1, **caractérisé en ce qu'**il comprend en outre, après l'étape de gravure principale, une étape de surgravure au moyen d'un plasma gazeux haute densité d'un mélange de gaz constitué de Cl₂ et de N₂ ou NH₃.

3. Procédé de gravure selon la revendication 1 ou 2, **caractérisé en ce que** l'étape de gravure principale est arrêtée avant d'atteindre le substrat.

4. Procédé selon la revendication 3, **caractérisé en ce que** l'arrêt de l'étape de gravure principale s'effectue 30 à 40 nm avant d'atteindre le substrat.

5. Procédé selon l'une quelconque des revendications précédentes, **caractérisé en ce que** la deuxième couche de l'empilement est une couche de Si polycristallin.

6. Procédé selon l'une quelconque des revendications précédentes, **caractérisé en ce que** la couche de Si₁₋ₓGeₓ polycristallin a une teneur en germanium égale ou supérieure à 50% (x ≥ 0,5).

7. Procédé selon l'une quelconque des revendications précédentes, **caractérisé en ce que** le substrat est une couche d'oxyde de silicium déposée sur une pastille de silicium.

8. Procédé selon la revendication 7, **caractérisé en ce que** la couche de Si₁₋ₓGeₓ ou l'empilement gravé constitue une structure de grille d'un dispositif semi-conducteur CMOS.

## Patentansprüche

1. Verfahren zum Ätzen einer Schicht einer polykristallinen Mischung Si₁₋ₓGeₓ (0 < x ≤ 1), wobei die Schicht auf ein Substrat oder einen Stapel aufgetragen ist, umfassend eine erste Schicht einer polykristallinen Mischung Si₁₋ₓGeₓ (0 < x ≤ 1), die auf ein Substrat aufgetragen ist, und eine zweite Siliziumschicht auf der ersten Schicht, wobei die Schicht oder der Stapel auf ihrer bzw. seiner Oberfläche eine Maske aus anorganischem Material umfasst, **dadurch gekennzeichnet, dass** das Verfahren einen Schritt des anisotropen Hauptätzens der Si₁₋ₓGeₓ-Schicht oder des Stapels unter Verwendung der Maske mittels eines gasförmigen Plasmas hoher Dichte eines Gasgemischs, das aus Chlor (Cl₂) und entweder Stickstoff (N₂) oder Ammoniak (NH₃) oder einer Mischung aus Stickstoff und Ammoniak besteht, umfasst.

2. Ätzverfahren nach Anspruch 1, **dadurch gekennzeichnet, dass** das Verfahren ferner nach dem Schritt des Hauptätzens einen Schritt des Überätzens mittels eines gasförmigen Plasmas hoher Dichte einer Gasmischung, die aus Cl₂ und N₂ oder NH₃ besteht, umfasst.

3. Ätzverfahren nach Anspruch 1 oder 2, **dadurch gekennzeichnet, dass** der Schritt des Hauptätzens vor dem Erreichen des Substrats gestoppt wird.

4. Verfahren nach Anspruch 3, **dadurch gekennzeichnet, dass** das Stoppen des Schritts des Hauptätzens 30 bis 40 nm vor dem Erreichen des Substrats erfolgt.

5. Verfahren nach einem der vorhergehenden Ansprüche, **dadurch gekennzeichnet, dass** die zweite Schicht des Stapels eine Schicht von polykristallinem Si ist.

6. Verfahren nach einem der vorhergehenden Ansprüche, **dadurch gekennzeichnet, dass** die Schicht von polykristallinem Si₁₋ₓGeₓ einen Germaniumgehalt von gleich oder größer 50% (x ≥ 0,5) aufweist.

7. Verfahren nach einem der vorhergehenden Ansprüche, **dadurch gekennzeichnet, dass** das Substrat eine Siliziumoxidschicht ist, die auf eine Siliziumpille aufgetragen wird.

8. Verfahren nach Anspruch 7, **dadurch gekennzeichnet, dass** die Si₁₋ₓGeₓ-Schicht oder der geätzte Stapel eine Rasterstruktur einer CMOS-Halbleitervorrichtung darstellt.

## Claims

1. Process for etching a layer of a polycrystalline Si₁₋ₓGeₓ (0 < x ≤ 1) mixture deposited on a substrate or for etching a stack comprising a first layer of a polycrystalline Si₁₋ₓGeₓ (0 < x ≤ 1) mixture deposited on a substrate and a second silicon layer deposited on the first layer, the said layer or the said stack including, on its surface, a mask of inorganic material, **characterized in that** it comprises a main etching step in which the said Si₁₋ₓGeₓ layer or the said stack is anisotropically etched, using the said mask, by means of a high-density gas plasma of a gas mixture consisting of chlorine (Cl₂) and of either nitrogen (N₂) or ammonia (NH₃) or of a nitrogen/ammonia mixture.

2. Etching process according to Claim 1, **characterized in that** it furthermore comprises, after the main etching step, an overetching step using a high-density gas plasma of a gas mixture consisting of Cl₂ and of N₂ or NH₃.

3. Etching process according to Claim 1 or 2, **characterized in that** the main etching step is stopped before the substrate is reached.

4. Process according to Claim 3, **characterized in that** the main etching step is stopped 30 to 40 nm before the substrate is reached.

5. Process according to any one of the preceding claims, **characterized in that** the second layer of the stack is a polycrystalline Si layer.

6. Process according to any one of the preceding claims, **characterized in that** the polycrystalline Si₁₋ₓGeₓ layer has a germanium content equal to or greater than 50% (x ≥ 0.5).

7. Process according to any one of the preceding claims, **characterized in that** the substrate is a silicon oxide layer deposited on a silicon wafer.

8. Process according to Claim 7, **characterized in that** the etched stack or Si₁₋ₓGeₓ layer constitutes a gate structure of a CMOS semiconductor device.
